# EUROPEAN PATENT APPLICATION

(11) **EP 4 266 355 A1**
(43) Date of publication of application: **25.10.2023**
(21) Application number: 21908790.5
(22) Date of filing: 20.10.2021
(51) Int. Cl.: H01L 21/48, H01L 23/49, H01L 21/56, H01L 23/498, H01L 23/31

(54) **SEMICONDUCTOR PACKAGING METHOD AND SEMICONDUCTOR PACKAGING STRUCTURE**

(30) Priority: 21.12.2020 CN 202011519686
(71) Applicant: SIPLP Microelectronics (Chongqing) Co., Ltd., Chongqing 401331 (CN)
(72) Inventor: HUO, Yan, Chongqing 401331 (CN); TU, Xufeng, Chongqing 401331 (CN)
(74) Representative: Patentship Patentanwaltsgesellschaft mbH
(86) International application number: PCT/CN2021/124847
(87) International publication number: WO 2022/134789

(57) **Abstract**

This present application provides a semiconductor packaging method and a semiconductor packaging structure. The semiconductor packaging method includes: forming an encapsulating structure, the encapsulating structure including an encapsulation layer and a chip, the chip provided on a front side thereof with a plurality of bonding pads, the encapsulation layer covering at least side faces of the chip; forming a rewiring layer on the side of the encapsulating structure close to the front side of the chip, the rewiring layer configured for external connection of the bonding pads on the chip; forming a dielectric layer, the dielectric layer covering the rewiring layer, the dielectric layer provided therein with a through hole in which the rewiring layer is exposed; and forming a pin layer on the side of the dielectric layer away from the chip, the pin layer electrically connected to the rewiring layer through the through hole.

## Description

### TECHNICAL FIELD

The present application relates to the technical field of semiconductor and, in particular, to a semiconductor packaging method and a semiconductor packaging structure.

### BACKGROUND

Common semiconductor packaging techniques such as chip packaging techniques essentially include, for a chip having a front side to be processed, attachment of the chip at its front side to a carrier substrate, plastic-encapsulation by thermal compression molding, stripping away of the carrier substrate, formation of a rewiring layer on the front side of the chip and a pin layer on the side of the rewiring layer away from the chip, and subsequent formation of an insulating layer covering the rewiring layer, with a surface of the pin layer away from the chip being exposed from the insulating layer.

In these chip packaging techniques, the pin layer is formed on the side of the rewiring layer away from the chip, and the rewiring layer has a larger area compared to the pin layer. Therefore, the rewiring layer has a large area itself, as well as a large contact area with the adjacent insulating layer. Due to quite different thermal expansion coefficients of the rewiring layer and the insulating layer, there may be a significant stress difference between the rewiring layer and the insulating layer caused by a temperature rise of the rewiring layer during fabrication or operation of the chip. This may lead to separation of the rewiring layer from the insulating layer or warpage of the rewiring layer, which is harmful to normal operation of the product.

### SUMMARY OF THE INVENTION

Embodiments of the present application provide a semiconductor packaging method and a semiconductor packaging structure.

According to a first aspect of embodiments of the present application, there is provided a semiconductor packaging method, comprising:
forming an encapsulating structure, the encapsulating structure comprising an encapsulation layer and a chip, the chip provided on a front side thereof with a plurality of bonding pads, the encapsulation layer covering at least a side face of the chip;
forming a rewiring layer on a side of the encapsulating structure close to the front side of the chip, the rewiring layer configured for external connection of the bonding pads on the chip;
forming a dielectric layer, the dielectric layer covering the rewiring layer, the dielectric layer provided therein with a through hole in which the rewiring layer is exposed; and
forming a pin layer on a side of the dielectric layer away from the chip, the pin layer electrically connected to the rewiring layer through the through hole.

According to a second aspect of embodiments of the present application, there is provided a semiconductor packaging structure, comprising:
an encapsulating structure, the encapsulating structure comprising an encapsulation layer and a chip, the chip provided on a front side thereof with a plurality of bonding pads, the encapsulation layer covering a backside and side faces of the chip;
a rewiring layer located on a side of the encapsulating structure close to the front side of the chip, the rewiring layer configured for external connection of the bonding pads on the chip;
a dielectric layer covering the rewiring layer, the dielectric layer provided therein with a through hole in which the rewiring layer is exposed; and
a pin layer located on a side of the dielectric layer away from the chip, the pin layer electrically connected to the rewiring layer through the through hole.

Major benefits of embodiments of the present application are as follows: in the semiconductor packaging method and structure according to embodiments of the present application, the dielectric layer covers the rewiring layer, and the pin layer is formed on the side of the dielectric layer away from the rewiring layer so as to be electrically connected to the rewiring layer through the through hole in the dielectric layer. In this way, there is no direct contact between the pin layer and the rewiring layer, making the size of the pin layer independent of the size of the rewiring layer. Thus, the rewiring layer is allowed to have a relatively small size and hence a smaller contact area with an adjacent insulating layer (e.g., the dielectric layer). This results in a reduced stress difference between the rewiring layer and the adjacent insulating layer and thereby lowers the risk of separation of the rewiring layer from the adjacent insulating layer or warpage of the rewiring layer, thus helping to boost product quality. Since the pin layer is not in direct contact with the rewiring layer, a thickness of the pin layer is less dependent on the rewiring layer. Therefore, the thickness of the pin layer can be more freely designed, for example, increased, to allow the semiconductor packaging structure to have a higher breakdown voltage, which helps to allow the semiconductor packaging structure to be used in high-voltage applications and thus have a wider scope of application.

The details of one or more embodiments of the application are set forth in the accompanying drawings and the description below. Other features, objects, and advantages of the application will be apparent from the description and drawings, and from the claims.

### BRIEF DESCRIPTION OF THE DRAWINGS

Fig. 1 shows a flow diagram of a semiconductor packaging method according to an exemplary embodiment of the present application;
Fig. 2 shows a flow diagram of a process of forming an encapsulating structure according to an exemplary embodiment of the present application;
Fig. 3 shows a partial sectional view of a first intermediate structure of a semiconductor packaging structure according to an exemplary embodiment of the present application;
Fig. 4 shows a partial sectional view of a second intermediate structure of a semiconductor packaging structure according to an exemplary embodiment of the present application;
Fig. 5 shows a partial sectional view of an encapsulating structure according to an exemplary embodiment of the present application;
Fig. 6 shows a partial sectional view of a third intermediate structure of a semiconductor packaging structure according to another exemplary embodiment of the present application;
Fig. 7 shows a partial sectional view of a third intermediate structure of a semiconductor packaging structure according to another exemplary embodiment of the present application;
Fig. 8 shows a partial sectional view of a fourth intermediate structure of a semiconductor packaging structure according to another exemplary embodiment of the present application;
Fig. 9 shows a partial sectional view of a fifth intermediate structure of a semiconductor packaging structure according to another exemplary embodiment of the present application;
Fig. 10 shows a partial sectional view of a sixth intermediate structure of a semiconductor packaging structure according to another exemplary embodiment of the present application;
Fig. 11 is a schematic diagram showing the structure of a sixth intermediate structure of a semiconductor packaging structure according to another exemplary embodiment of the present application;
Fig. 12 shows a partial sectional view of a semiconductor packaging structure according to an exemplary embodiment of the present application;
Fig. 13 shows a partial sectional view of a semiconductor packaging structure according to an exemplary embodiment of the present application, which has been welded to a circuit board.
Fig. 14 shows a partial sectional view of a semiconductor packaging structure according to another exemplary embodiment of the present application.

### DETAILED DESCRIPTION

Here, exemplary embodiments will be described in detail, examples of which are shown in the accompanying drawings. When referring to the drawings below, unless otherwise indicated, like numerals throughout different ones of them represent the same or similar elements. The exemplary embodiments described hereunder do not represent all possible embodiments consistent with the present application. Rather, they are merely examples of devices and methods consistent with some aspects of this disclosure as detailed in the appended claims.

The terminology used herein is for the purpose of describing particular embodiments only and is not intended to be limiting of this application. As used herein and in the appended claims, the singular forms "a", "an", and "the" are intended to include the plural forms as well, unless the context clearly indicates otherwise. It will be also understood that, as used herein, the term "and/or" includes any and all combinations of one or more of the associated listed items.

It should be understood that although the terms such as "first", "second", "third" and the like may be used herein to describe various types of information, such information is not limited to these terms. These terms serve only to distinguish between information of the same type. For example, without departing from the scope of the present application, "first information" may be alternatively referred to as "second information". Similarly, "second information" may be alternatively referred to as "first information". Depending on the context, the term "if' as used herein may be interpreted as "when", "upon" or "in response to a determination that ..."

Several embodiments of the present application will be described in detail with reference to the accompanying drawings. Whenever there is no conflict, the following embodiments and features thereof can be combined with one another.

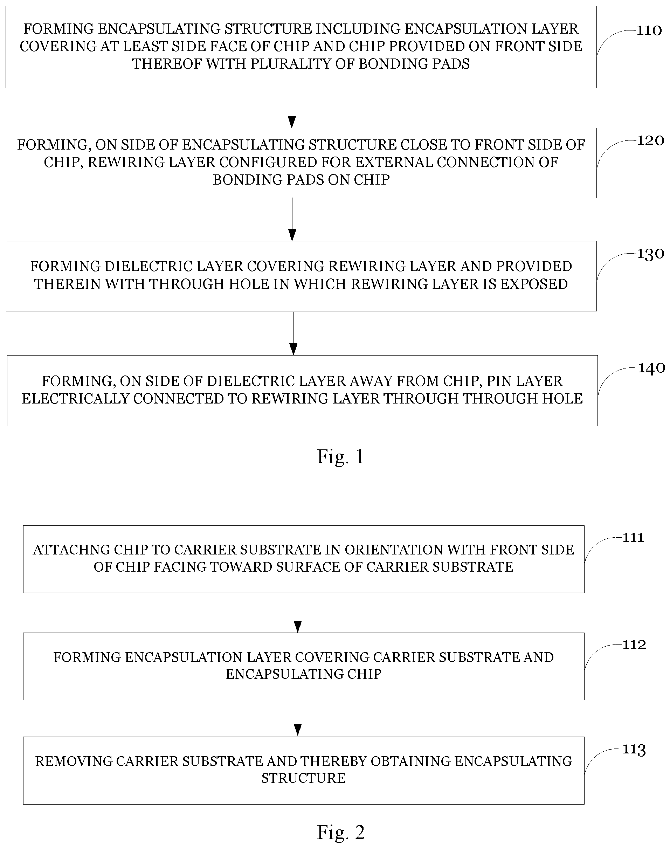

Embodiments of the present application provide a semiconductor packaging method. Referring to Fig. 1, the semiconductor packaging method includes the steps 110 to 140 as detailed below.

In step 110, an encapsulating structure is formed. The encapsulating structure includes an encapsulation layer and a chip. The chip is provided on a front side thereof with a plurality of bonding pads. The encapsulation layer covers at least a side face of the chip.

In step 120, a rewiring layer is formed on the side of the encapsulating structure close to the front side of the chip. The rewiring layer is formed to enable external connection of the bonding pads on the chip.

In step 130, a dielectric layer is formed. The dielectric layer covers the rewiring layer and is provided with a through hole in which the rewiring layer is exposed.

In step 140, a pin layer is formed on the side of the dielectric layer away from the chip. The pin layer is electrically connected to the rewiring layer through the through hole.

In the semiconductor packaging method according to such embodiments of the present application, the dielectric layer covers the rewiring layer, and the pin layer is formed on the side of the dielectric layer away from the rewiring layer so as to be electrically connected to the rewiring layer through the through hole in the dielectric layer. In this way, there is no direct contact between the pin layer and the rewiring layer, making the size of the pin layer independent from the size of the rewiring layer. Thus, the rewiring layer is allowed to have a smaller size and hence a smaller contact area with an adjacent insulating layer (e.g., the dielectric layer). This results in a reduced stress difference between the rewiring layer and the adjacent insulating layer and thereby lowers the risk of separation of the rewiring layer from the adjacent insulating layer or warpage of the rewiring layer, thus helping to boost product quality. Since the pin layer is not in direct contact with the rewiring layer, a thickness of the pin layer is less dependent on the rewiring layer. Therefore, the thickness of the pin layer can be more freely designed, for example, increased, to allow a semiconductor packaging structure being fabricated to have a higher breakdown voltage, which helps to allow the semiconductor packaging structure to be used in high-voltage applications and thus have a wider scope of application.

The steps in the semiconductor packaging method according to these embodiments of the present application will be described in detail below.

In step 110, an encapsulating structure is formed. The encapsulating structure includes an encapsulation layer and a chip. The chip is provided on a front side thereof with a plurality of bonding pads. The encapsulation layer covers at least side faces of the chip.

In one embodiment, the encapsulating structure may include one or more chips each placed in an associated respective concave cavity formed in the encapsulation layer.

In one embodiment, referring to Fig. 2, the formation of the encapsulating structure in step 110 includes steps 111 to 113 below.

In step 111, the chip is attached to a carrier substrate in an orientation with the front side of the chip facing toward a surface of the carrier substrate.

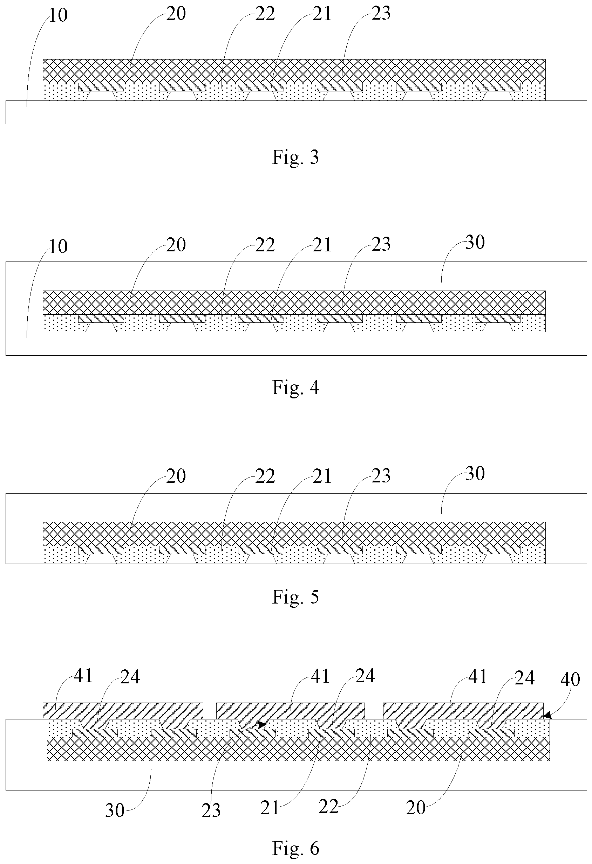

A first intermediate structure as shown in Fig. 3 can result from step 111. In the embodiment of Fig. 3, one chip 20 is attached to the carrier substrate 10. In other embodiments, a plurality of chips 20 may be attached to the carrier substrate 10.

In one embodiment, the carrier substrate 10 includes a reserved area for accommodating attachment of the chip 20. The reserved area has shape designed according to a layout of the chip 20 on the carrier substrate 10. Examples of the shape of the reserved area may include circular, rectangular and other shapes. The carrier substrate 10 may include one or more such reserved areas.

In one embodiment, the shape of the carrier substrate 10 may be circular, rectangular or otherwise. The carrier substrate 10 may be formed of a controlled expansion iron-nickel alloy, stainless steel, a polymer or the like.

In one embodiment, the chip 20 can be obtained by dicing a wafer. The wafer may have an active surface on which the bonding pads are provided. The dicing of the wafer may be accomplished either mechanically or using a laser. Optionally, before the wafer is diced, the wafer may be thinned using a grinder on the side opposite to the active surface until it has a designated thickness.

The bonding pads 21 on the chip 20 are made up of conductive electrodes configured for external connection of the internal circuitry in the chip to the chip surface. A plurality of bonding pads 21 may be provided on the front side of the chip 20. The bonding pads 21 are adapted for external connection of the conductive electrodes of the chip.

In one embodiment, before the chip is attached to the carrier substrate in step 111, the semiconductor packaging method further includes forming a protective layer 22 on the front side of the chip 20. The protective layer 22 is provided therein with openings 23 in which the respective bonding pads 21 are exposed.

In some embodiments, the openings 23 may be formed in the protective layer 22 using a laser. The openings 23 may be sized smaller than the respective bonding pads 21 so that surfaces of the respective bonding pads 21 away from the carrier substrate 10 are partially exposed in the openings 23.

The protective layer 22 may be formed of a plastic encapsulation film, polyimide (PI), polybenzoxazole (PBO), an organic polymer film, an organic polymeric composite material or another material with similar properties. In some embodiments, the protective layer 22 may be further added with an organic or inorganic filler.

In step 112 that follows, in which the encapsulation layer is molded, an encapsulating material of the encapsulation layer tends to penetrate between the carrier substrate 10 and the chip 20 due to a high pressure employed in the molding process. The protective layer 22 formed on the front side of the chip 20 can prevent the encapsulating material from penetrating up to the surface of the chip 20. Moreover, even if the encapsulating material penetrates to the protective layer 22 during the formation of the encapsulation layer, after the carrier substrate 10 is stripped away from the chip 20, a surface of the protective layer 22 can be directly chemically treated or ground, with the front side of the chip 20 not being affected at all. In this way, damage to the bonding pads on the front side of the chip 20 can be avoided.

In one embodiment, the chip 20 may be attached to the carrier substrate 10 by an adhesive layer. The adhesive layer may be implemented as an easily strippable material which allows subsequent separation of the chip 20 from the carrier substrate 10. For example, the adhesive layer may be implemented as a thermally separable material that will lose its adhesiveness when heated.

In step 112, the encapsulation layer is formed, which covers the carrier substrate and encapsulates the chip.

A second intermediate structure as shown in Fig. 4 can result from step 112.

Referring to Fig. 4, the encapsulation layer 30 resides on the chip 20 and the carrier substrate 10 not covered thereby. In this way, it encapsulates the chip 20, resulting in a structure resembling a flat plate. In this way, after the carrier substrate 10 is stripped away, rewiring and packaging can be performed on the flat-plate-like structure.

In one embodiment, prior to the formation of the encapsulation layer 30, preliminary steps such as chemical or plasma cleaning may be carried out to remove undesirable matter from surfaces of the chip 20 and the carrier substrate 10 to enable stronger adhesion of the encapsulation layer 30 to the chip 20 and the carrier substrate 10 without separation or cracking.

In one embodiment, the encapsulation layer 30 may be formed by laminating epoxy resin films. Alternatively, it may be formed of an epoxy resin compound using injection molding, compression molding, transfer molding or another technique.

In one embodiment, the formation of the encapsulation layer in step 112 may include the steps as follows.

At first, the encapsulating structure is so formed as to cover the carrier substrate and encapsulate the chip. In this step, the encapsulating structure has a greater thickness compared to the chip 20 and thus totally encapsulates the chip 20.

Subsequently, the encapsulation layer is obtained by thinning the encapsulating structure on the side away from the carrier substrate. In this step, the encapsulating structure may be thinned using a grinding technique until it has a designated thickness.

In step 113, the carrier substrate is removed, resulting in the formation of the encapsulating structure.

The encapsulating structure resulting from step 113 is shown in Fig. 5. In the embodiment of Fig. 5, the encapsulation layer 30 encapsulates the chip 20 at a backside and side faces thereof. In other embodiments, the encapsulation layer 30 may encapsulate the chip 20, for example, only at its side faces.

In one embodiment, the carrier substrate 10 may be directly stripped away from the encapsulation layer 30 and the chip 20 in a mechanical manner. In another embodiment in which the chip 20 is bonded to the carrier substrate 10 by an adhesive layer of a thermally separable material, heat may be provided to reduce adhesiveness of the adhesive layer, followed by stripping away of the carrier substrate 10. As a result of the carrier substrate 10 being stripped away, the bonding pads on the chip 20 are exposed.

In step 120, a rewiring layer is formed on the side of the encapsulating structure close to the front side of the chip. The rewiring layer is formed to enable external connection of the bonding pads on the chip.

A third intermediate structure as shown in Fig. 6 can result from step 120. The side of the encapsulating structure close to the front side of the chip refers to the side thereof where the front side of the chip is located. Referring to Fig. 6, the rewiring layer 40 includes a plurality of rewiring structures 41, each of which may be electrically connected to one or more of the bonding pads 21.

In one embodiment, conductive structures 24 are formed in the respective openings 23 in the protective layer 22 so as to be in direct contact with the rewiring structures 41. As a result, the rewiring structures 41 are electrically connected to the bonding pads 21 via the conductive structures 24. The conductive structures 24 may be formed in the same process step in which the rewiring structures 41 are formed, thus making the semiconductor packaging process simpler.

In one embodiment, step 120 may include the following steps.

First of all, a seed layer is formed on the side of the encapsulating structure close to the front side of the chip. The seed layer may cover the front side of the chip 20 and inner sidewalls of the openings 23.

A photoresist layer is formed on the side of the seed layer away from the chip. The photoresist layer is a patterned film.

Afterwards, the seed layer is connected to a power supply, and an electroplating process is initiated to form a conductive layer on the side of the seed layer away from the chip over regions uncovered by the photoresist layer.

The photoresist layer is then removed.

After that, the seed layer is patterned to remove parts thereof not covered by the conductive layer. The remaining seed layer and the conductive layer make up the rewiring layer.

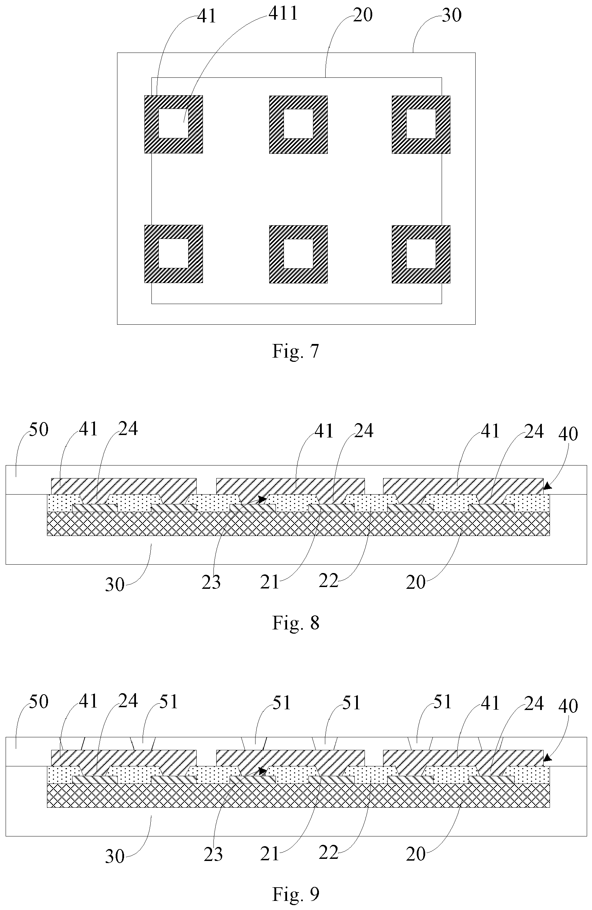

In one embodiment, referring to Fig. 7, rewiring structures 41 have hollows 411. This can reduce the footprint of the rewiring structures 41 and hence the contact area thereof with the adjacent insulating layer, additionally lowering the risk of separation of the rewiring structures 41 from the adjacent insulating layer.

In step 130, a dielectric layer is formed, which covers the rewiring layer and is provided therein with through hole in which the rewiring layer is exposed.

In one embodiment, step 130 may include the following steps.

At first, the dielectric layer is formed over the encapsulating structure. The dielectric layer covers the rewiring layer 40 and each exposed portion of the encapsulation layer 30.

A fourth intermediate structure as shown in Fig. 8 can result from this step. Referring to Fig. 8, the dielectric layer 50 totally wraps the rewiring layer 40.

The through hole in which the rewiring layer is exposed are then formed in the dielectric layer.

A fifth intermediate structure as shown in Fig. 9 can result from this step. Referring to Fig. 9, a plurality of through holes 51 are formed in the dielectric layer 50. One or more of the through holes 51 may be formed in the dielectric layer 50 vertically above each rewiring structure 41. That is, each rewiring structure 41 may correspond to one or more of the through holes 51. The through holes 51 are sized smaller than the rewiring structures 41 so that surfaces of the rewiring structures 41 are partially exposed in the through holes 51.

In one embodiment, the dielectric layer 50 may be formed of a plastic encapsulation film, PI, PBO, an organic polymer film, an organic polymeric composite material or another material with similar properties. In some embodiments, the dielectric layer 50 may be further added with an organic or inorganic filler.

In one embodiment, the through holes 51 may be formed in the dielectric layer 50 using a laser.

In step 140, a pin layer is formed on the side of the dielectric layer away from the chip so as to be electrically connected to the rewiring layer through the through hole.

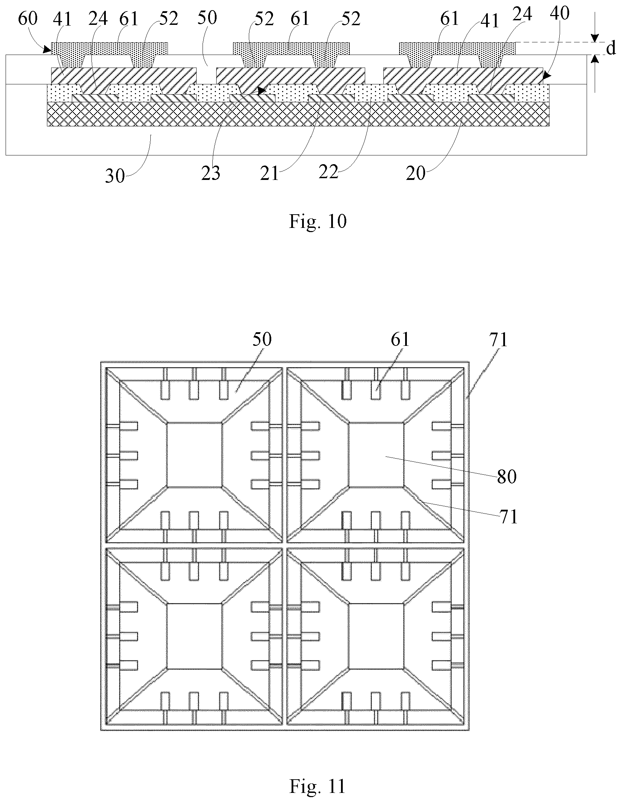

A sixth intermediate structure as shown in Fig. 10 can result from step 140. Referring to Fig. 10, the pin layer 60 includes a plurality of conductive pillars 61, which are spaced apart from one another and raised from the dielectric layer 50.

Since the pin layer 60 is located on the side of the dielectric layer 50 away from chip 20, with the conductive pillars 61 being raised from the dielectric layer 50, it is unnecessary to grind the dielectric layer 50. In comparison with the case in which the dielectric layer is formed after the pin layer has been formed and is ground so that the pin layer is exposed therefrom, this can save the time taken to grind the dielectric layer, resulting in increased packaging efficiency and reduced fabrication cost. Moreover, a non-uniform thickness of the dielectric layer that may be caused by insufficient accuracy of the grinding process used, possible damage caused to the pin layer during the grinding of the dielectric layer, and possible damage to the bonding pads on the chip caused by stress on the pin layer, can be avoided, thus helping to boost quality of the resulting packaged product.

In one embodiment, conductive features 52 are formed in the respective through holes 51 in the dielectric layer 50 so as to be in direct contact with both the rewiring structures 41 and the conductive pillars 61. In this way, the conductive pillars 61 are electrically connected to the rewiring structures 41 by the conductive features 52. The conductive pillars 61 and the conductive features 52 may be formed in a single process step, additionally simplifying the semiconductor packaging process.

In one embodiment, the pin layer 60 may be formed on the side of the dielectric layer 50 away from the chip 20 using an electroplating process. Since the pin layer 60 is formed on the dielectric layer 50 and is not in direct contact with the rewiring layer 40, it may have a relatively great thickness by forming a relatively thick conductive layer on the side of the dielectric layer 50 away from chip 20 in the electroplating process and then etching the thick conductive layer.

In one embodiment, the thickness d of the pin layer 60 may exceed 30 µm. This enables the semiconductor packaging structure to have an effectively increased breakdown voltage. In some embodiments, the conductive features 52 and the pin layer 60 may be formed simultaneously. This can avoid breakage of any conductive feature 52 around an inner sidewall of the corresponding through hole 51 due to a small thickness of the conductive feature 52. In some embodiments, the thickness d of the pin layer 60 is, for example, 31 µm, 33 µm, 35 µm, 37 µm, 40 µm, etc.

In one embodiment, the semiconductor packaging method further includes forming a heat dissipation layer on the side of the dielectric layer 50 away from the chip 20.

Referring to Fig. 11, the heat dissipation layer 80 has a large area, which enables the semiconductor packaging structure to have good heat dissipation performance. Such a heat dissipation layer 80 may be formed for each chip 20. The conductive pillars 61 in each chip 20 may be arranged to surround the heat dissipation layer 80.

In one embodiment, the heat dissipation layer 80 may be formed in the same process step in which the pin layer 60 is formed. This can make the semiconductor packaging process further simpler. In this way, the heat dissipation layer 80 can be entirely raised from the dielectric layer 50.

In one embodiment, after the pin layer is formed on the side of the dielectric layer away from the chip in step 140, the semiconductor packaging method further includes forming a solder layer, which covers surfaces of the conductive pillars that are raised from the surface of the dielectric layer.

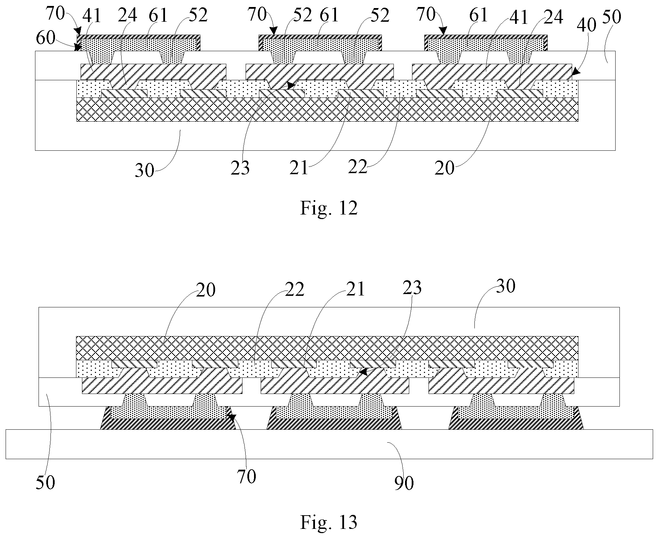

After this step, the semiconductor packaging structure as shown in Fig. 12 can be obtained.

As the conductive pillars 61 in the pin layer 60 are formed on the side of the dielectric layer 50 away from the chip 20 so as to be all raised from the dielectric layer 50, during the formation of the solder layer 70, the solder may have good climbing ability, enabling the resulting solder layer 70 to cover all the surfaces of the conductive pillars 61 raised from the surface of the dielectric layer, i.e., side surfaces and a surface of the conductive pillars 61 away from the chip 20. In this way, as shown in Fig. 13, when the semiconductor packaging structure is welded to a circuit board 90, each conductive pillar 61 can be welded to the circuit board 90 at all its side surfaces and the surface away from the chip 20 through the solder layer 70. In comparison with the case where each conductive pillar is exposed from the dielectric layer and covered by the solder layer only at the surface away from the chip, this semiconductor packaging structure obtained in accordance with the embodiments of the present application exhibits improved welding reliability between the conductive pillars 61 and the circuit board 90. Further, compared with the formation of solder balls using a reflow soldering process, the embodiments of the present application allows for a simpler process.

In some embodiments, the solder layer 70 may be tin, a gold-tin alloy, a nickel-based alloy or another material suitable for use as a solder.

In some embodiments, the solder layer 70 may be formed using electroplating, electroless plating, screen printing or another suitable technique. In some embodiments, the solder layer 70 may be formed on the surfaces of the respective conductive pillars 61 by an electroplating process. This enables the semiconductor packaging structure to have a more controllable overall thickness while ensuring thickness uniformity thereof. For panel-level packaging, this can result in effectively increased packaging efficiency and help to reduce cost. Further, the resulting solder layer 70 is allowed to have an increased thickness, which enables the semiconductor packaging structure to be more reliably welded to another structure.

In one embodiment, since the heat dissipation layer 80 is formed on the side of the dielectric layer 50 away from the chip 20 and is raised from the dielectric layer 50, during the formation of the solder layer 70, the solder may have good climbing ability, enabling the resulting solder layer 70 to cover all the surfaces of the heat dissipation layer 80 raised from the surface of the dielectric layer, i.e., side surface and a surface of the heat dissipation layer 80 away from the chip 20. In this way, when the semiconductor packaging structure is welded to the circuit board 90, the heat dissipation layer 80 can be welded to the circuit board at all its side surfaces and the surface away from the chip 20 through the solder layer 70. In comparison with the case where the heat dissipation layer is exposed from the dielectric layer and covered by the solder layer only at the surface away from the chip, this semiconductor packaging structure obtained in accordance with the embodiments of the present application exhibits improved welding reliability between the heat dissipation layer 80 and the circuit board 90.

In one embodiment, referring again to Fig. 11, during the formation of the solder layer 70, tin-plating wires 71 electrically connecting the conductive pillars 61 and the heat dissipation layer 80 are formed and then electrically connected to an external power supply. An electroplating process is initiated to form the solder layer 70 over the side surfaces of the conductive pillars 61 and the surfaces thereof away from the chip 20, as well as over the side surfaces of the heat dissipation layer 80 and the surfaces thereof away from the chip 20.

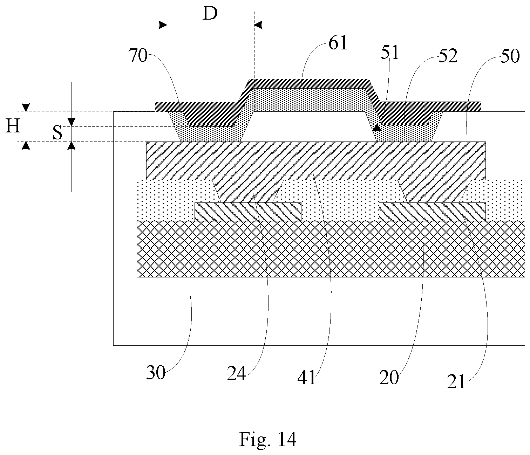

In one embodiment, referring to Fig. 14, the through holes 51 are sized large enough to avoid breakage of any conductive feature 52 around an inner sidewall of the corresponding through hole 51. The solder layer 70 fills recesses formed by the conductive features 52. In this way, a larger contact area and hence stronger adhesion can be obtained between the solder layer 70 and the conductive pillars 61 in the pin layer 60, and a large enough space can be provided to enable the solder layer 70 to have a sufficient thickness, which helps to ensure welding reliability between the semiconductor packaging structure and the circuit board 90.

In some embodiments, a width D to depth H ratio of the through holes 51 is greater than or equal to 1/3. This causes the conductive features 52 more likely to recess in the through holes 51, which helps to obtain a larger contact area between the conductive pillars 61 and the solder layer 70. The width D to depth H ratio of the through holes 51 is, for example, 1/3, 1/2, 2/3, 3/4, 3/2 or the like.

In one embodiment, the depth H of the through holes 51 ranges from 60 µm to 100 µm, and the conductive features 52 at the bottom of the through holes 51 have a thickness S ranging from 10 µm to 50 µm. This helps to provide sufficient spaces in the through holes 51 to be filled by the solder layer 70, resulting in improved welding reliability between the semiconductor packaging structure and another structure. In some embodiments, the depth H of the through holes 51 (referred to hereinafter as the "depth H" for short) is 100 µm, and the thickness S of the conductive features 52 at the bottom of the through holes 51 (referred to hereinafter as the "thickness S" for short) is 40 µm. Moreover, the width D of the through holes 51 (referred to hereinafter as the "width D" for short) is 50 µm. Alternatively, the depth H is 80 µm, the thickness S is 35 µm, and the width D is 40 µm or 80 µm. Still alternatively, the depth H is 60 µm, the thickness S is 25 µm, and the width D is 30 µm or 80 µm. Other embodiments are also possible.

Embodiments of the present application also provide a semiconductor packaging structure. Referring to Figs. 12 to 14, the semiconductor packaging structure include an encapsulating structure, a rewiring layer 40, a dielectric layer 50 and a pin layer 60.

The encapsulating structure includes an encapsulation layer 30 and a chip 20 provided on a front side thereof with a plurality of bonding pads 21. The encapsulation layer 30 covers at least side faces of the chip 20. The rewiring layer 40 is located on the side of the encapsulating structure close to the front side of the chip 20, and the rewiring layer 40 is adapted for external connection of the bonding pads 21 on the chip 20. The side of the encapsulating structure close to the front side of the chip 20 refers to the side of the encapsulating structure where the front side of the chip is located. The dielectric layer 50 covers the rewiring layer 40 and provided therein with through holes 51 in which the rewiring layer 40 is partially exposed. The pin layer 60 is located on the side of the dielectric layer 50 away from the chip 20 and electrically connected to the rewiring layer 40 through the through holes 51.

In the semiconductor packaging structure according to such embodiments of the present application, the dielectric layer covers the rewiring layer, and the pin layer is formed on the side of the dielectric layer away from the rewiring layer so as to be electrically connected to the rewiring layer through the through holes in the dielectric layer. In this way, there is no direct contact between the pin layer and the rewiring layer, making the size of the pin layer independent of the size of the rewiring layer. Thus, the rewiring layer is allowed to have a smaller size and hence a smaller contact area with an adjacent insulating layer (e.g., the dielectric layer). This results in a reduced stress difference between the rewiring layer and the adjacent insulating layer and thereby lowers the risk of separation of the rewiring layer from the adjacent insulating layer or warpage of the rewiring layer, thus helping to boost product quality. Since the pin layer is not in direct contact with the rewiring layer, a thickness of the pin layer is less dependent on the rewiring layer. Therefore, the thickness of the pin layer can be more freely designed, for example, increased, to allow the semiconductor packaging structure to have a higher breakdown voltage, which helps to allow the semiconductor packaging structure to be used in high-voltage applications and thus have a wider scope of application.

In one embodiment, a protective layer 22 is formed on the front side of the chip 20. The protective layer 22 is provided with openings 23 in which the bonding pads 21 are exposed. The openings 23 may be sized smaller than the bonding pads 21 so that surfaces of the bonding pads 21 away from a carrier substrate 10 can be partially exposed in the openings 23.

The protective layer 22 may be formed of a plastic encapsulation film, PI, PBO, an organic polymer film, an organic polymeric composite material or another material with similar properties. In some embodiments, the dielectric layer 50 may be further added with an organic or inorganic filler. In some embodiments, the protective layer 22 may be further added with an organic or inorganic filler.

The encapsulation layer is molded under a high pressure. In this process, an encapsulating material of the encapsulation layer tends to penetrate between the carrier substrate 10 and the chip 20. The protective layer 22 formed on the front side of the chip 20 can prevent the encapsulating material from penetrating up to the surface of the chip 20. Moreover, even if the encapsulating material penetrates to the protective layer 22 during the formation of the encapsulation layer, after the carrier substrate 10 is stripped away from the chip 20, a surface of the protective layer 22 can be directly chemically treated or ground, with the front side of the chip 20 not being affected at all. In this way, damage to the bonding pads on the front side of the chip 20 can be avoided.

In one embodiment, conductive structures 24 are formed in the respective openings 23 in the protective layer 22 so as to be in direct contact with rewiring structures 41. As a result, the rewiring structures 41 are electrically connected to the bonding pads 21 via the conductive structures 24. The conductive structures 24 may be formed of the same material as that of the rewiring structures 41. In this case, the conductive structures 24 may be formed in the same process step in which the rewiring structures 41 are formed. This makes the packaging process for forming the semiconductor packaging structure simpler.

In one embodiment, the rewiring layer 40 includes a plurality of rewiring structures 41, which are spaced apart from one another, and each of which may be electrically connected to one or more of the bonding pads 21.

In one embodiment, referring to Fig. 7, the rewiring structures 41 have hollows 411. This can reduce the footprint of the rewiring structures 41 and hence the contact area thereof with the adjacent insulating layer, additionally lowering the risk of separation of the rewiring structures 41 from the adjacent insulating layer.

In one embodiment, a plurality of through holes 51 are formed in the dielectric layer 50. One or more of the through holes 51 may be formed in the dielectric layer 50 vertically above each rewiring structure 41. That is, each rewiring structure 41 may correspond to one or more of the through holes 51. The through holes 51 are sized smaller than the rewiring structures 41 so that surfaces of the rewiring structures 41 are partially exposed in the through holes 51.

In one embodiment, the dielectric layer 50 may be formed of a plastic encapsulation film, PI, PBO, an organic polymer film, an organic polymeric composite material or another material with similar properties. In some embodiments, the dielectric layer 50 may be further added with an organic or inorganic filler.

In one embodiment, the pin layer 60 includes a plurality of conductive pillars 61, which are spaced apart from one another and raised from the dielectric layer 50.

Since the pin layer 60 is located on the side of the dielectric layer 50 away from chip 20, with the conductive pillars 61 being raised from the dielectric layer 50, it is unnecessary to grind the dielectric layer 50. In comparison with the case in which the dielectric layer is formed after the pin layer has been formed and is ground so that the pin layer is exposed therefrom, this can save the time taken to grind the dielectric layer, resulting in increased packaging efficiency and reduced fabrication cost. Moreover, a non-uniform thickness of the dielectric layer that may be caused by insufficient accuracy of the grinding process used, possible damage caused to the pin layer during the grinding of the dielectric layer, and possible damage to the bonding pads on the chip caused by stress on the pin layer, can be avoided, thus helping to boost quality of the resulting packaged product.

In one embodiment, conductive features 52 are formed in the respective through holes 51 in the dielectric layer 50 so as to be in direct contact with both the rewiring structures 41 and the conductive pillars 61. In this way, the conductive pillars 61 are electrically connected to the rewiring structures 41 by the conductive features 52. The conductive pillars 61 may be formed of the same material as the conductive features 52. In this case, the conductive pillars 61 and the conductive features 52 may be formed in a single process step, additionally simplifying the packaging process for forming the semiconductor packaging structure.

In one embodiment, the pin layer 60 has a thickness d exceeding 30 µm. This enables the semiconductor packaging structure to have an effectively increased breakdown voltage. In some embodiments, the conductive features 52 and the pin layer 60 may be formed simultaneously. This can avoid breakage of any conductive feature 52 around an inner sidewall of the corresponding through hole 51. In some embodiments, the thickness d of the pin layer 60 is, for example, 31 µm, 33 µm, 35 µm, 37 µm, 40 µm, etc.

In one embodiment, referring to Fig. 11, the semiconductor packaging structure further includes a heat dissipation layer 80. The heat dissipation layer 80 has a large area, which enables the semiconductor packaging structure to have good heat dissipation performance. Such a heat dissipation layer 80 may be formed for each chip 20. The conductive pillars 61 in each chip 20 may be arranged to surround the heat dissipation layer 80.

In one embodiment, the heat dissipation layer 80 may be formed of the same material as the pin layer 60. In this case, the heat dissipation layer 80 may be formed in the same process step in which the pin layer 60 is formed, further simplifying the packaging process for forming the semiconductor packaging structure. The heat dissipation layer 80 may be entirely raised from the dielectric layer 50.

In one embodiment, the semiconductor packaging structure further includes a solder layer 70, which covers surfaces of the conductive pillars 61 that are raised from the surface of the dielectric layer 50.

As the conductive pillars 61 in the pin layer 60 are formed on the side of the dielectric layer 50 away from the chip 20 so as to be all raised from the dielectric layer 50, during the formation of the solder layer 70, the solder may have good climbing ability, enabling the resulting solder layer 70 to cover all the surfaces of the conductive pillars 61 raised from the surface of the dielectric layer, i.e., side surfaces and a surface thereof away from the chip 20. In this way, as shown in Fig. 13, when the semiconductor packaging structure is welded to a circuit board 90, each conductive pillar 61 can be welded to the circuit board 90 at all its side surfaces and the surface away from the chip 20 through the solder layer 70. In comparison with the case where each conductive pillar is exposed from the dielectric layer and covered by the solder layer only at the surface away from the chip, this semiconductor packaging structure according to the embodiments of the present application exhibits improved welding reliability between the conductive pillars 61 and the circuit board 90.

In one embodiment, since the heat dissipation layer 80 is formed on the side of the dielectric layer 50 away from the chip and is raised from the dielectric layer 50, during the formation of the solder layer 70, the solder may have good climbing ability, enabling the resulting solder layer 70 to cover all the surfaces of the heat dissipation layer 80 raised from the surface of the dielectric layer, i.e., side surface and a surface of the heat dissipation layer 80 away from the chip 20. In this way, when the semiconductor packaging structure is welded to the circuit board 90, the heat dissipation layer 80 can be welded to the circuit board at all its side surfaces, and the surface away from the chip 20 through the solder layer 70. In comparison with the case where the heat dissipation layer is exposed from the dielectric layer and covered by the solder layer only at the surface away from the chip, this semiconductor packaging structure according to the embodiments of the present application exhibits improved welding reliability between the heat dissipation layer 80 and the circuit board 90.

In some embodiments, the solder layer 70 may be made of tin, a gold-tin alloy, a nickel-based alloy or another material suitable for use as a solder.

In some embodiments, the solder layer 70 may be formed using electroplating, electroless plating, screen printing or another suitable technique. In some embodiments, the solder layer 70 may be formed on the surfaces of the respective conductive pillars 61 by an electroplating process. This enables the semiconductor packaging structure to have a more controllable overall thickness while ensuring thickness uniformity thereof. For panel-level packaging, this can result in effectively increased packaging efficiency and help to reduce cost. Further, the resulting solder layer 70 is allowed to have an increased thickness, which enables the semiconductor packaging structure to be more reliably welded to another structure.

In one embodiment, referring to Fig. 14, the through holes 51 are sized large so that the conductive features 52 recess in the through holes 51. The solder layer 70 fills the recesses. In this way, a larger contact area and hence stronger adhesion can be obtained between the solder layer 70 and the conductive pillars 61 in the pin layer 60, and the solder layer 70 can be thicker, which helps to ensure welding reliability between the semiconductor packaging structure and the circuit board 90.

In some embodiments, a width D to depth H ratio of the through holes 51 is greater than or equal to 1/3. This causes the conductive features 52 likely to recess in the through holes 51, which help to obtain a larger contact area between the conductive pillars 61 and the solder layer 70. The width D to depth H ratio of the through holes 51 is, for example, 1/3, 1/2, 2/3, 3/4, 3/2 or the like.

In one embodiment, the depth H of the through holes 51 ranges from 60 µm to 100 µm, and the conductive features 52 at the bottom of the through holes 51 have a thickness S ranging from 10 µm to 50 µm. This helps to provide sufficient spaces in the through holes 51 to be filled by the solder layer 70, resulting in improved welding reliability between the semiconductor packaging structure and another structure. In some embodiments, the depth H of the through holes 51 (referred to hereinafter as the "depth H" for short) is 100 µm, and the thickness S of the conductive features 52 at the bottom of the through holes 51 (referred to hereinafter as the "thickness S" for short) is 40 µm. Moreover, the width D of the through holes 51 (referred to hereinafter as the "width D" for short) is 50 µm. Alternatively, the depth H is 80 µm, the thickness S is 35 µm, and the width D is 40 µm or 80 µm. Still alternatively, the depth H is 60 µm, the thickness S is 25 µm, and the width D is 30 µm or 80 µm. Other embodiments are also possible.

As the semiconductor packaging method and structure according to embodiments of the present application belong to a same inventive concept, reference can be made among the above descriptions in connection with their details and benefits, and any duplicate description thereof is omitted.

It is to be noted that, in the drawings, the sizes of layers and regions may be exaggerated for clarity of illustration. It will be understood that when an element or a layer is referred to as being "on" another element or layer, it can be directly on the other element, or intervening layers may also be present. It will be also understood that when an element or a layer is referred to as being "between" two layers or two elements, it can be the only layer between the two layers or two elements, or one or more intervening layers or elements may also be present. Like reference numerals indicate like elements throughout.

Other embodiments of the present application will become apparent to those skilled in the art when they consider the specification and practice the disclosure herein. Accordingly, the present application is intended to cover all and any variations, uses, or adaptations of the disclosure which follow, in general, the principles thereof and include such departures from the present disclosure as come within common knowledge or customary practice within the art to which the application pertains. It is also intended that the specification and examples be considered as exemplary only, with true scope and spirit of the application being indicated by the appended claims.

It is to be understood that the present application is not limited to the exact structures as described above and illustrated in the figures and may be modified or changed without departing from its scope. The scope of the application is intended to be defined only by the appended claims.

## Claims

1. A semiconductor packaging method, comprising:
forming an encapsulating structure, the encapsulating structure comprising an encapsulation layer and a chip, the chip provided on a front side thereof with a plurality of bonding pads, the encapsulation layer covering at least a side face of the chip;
forming a rewiring layer on a side of the encapsulating structure close to the front side of the chip, the rewiring layer configured for external connection of the bonding pads on the chip;
forming a dielectric layer, the dielectric layer covering the rewiring layer, the dielectric layer provided therein with a through hole in which the rewiring layer is exposed; and
forming a pin layer on a side of the dielectric layer away from the chip, the pin layer electrically connected to the rewiring layer through the through hole.

2. The semiconductor packaging method according to claim 1, wherein the pin layer comprises a plurality of conductive pillars which are spaced apart from one another and raised from the dielectric layer, and wherein after the pin layer is formed on the side of the dielectric layer away from the chip, the semiconductor packaging method further comprises:
forming a solder layer, the solder layer covering a surface of the conductive pillars raised from the dielectric layer.

3. The semiconductor packaging method according to claim 1, wherein the pin layer comprises a plurality of conductive pillars which are spaced apart from one another and raised from the dielectric layer, and a conductive feature is provided in the through hole so that the pin layer is electrically connected to the rewiring layer by the conductive feature, wherein a recess is formed in the the conductive feature in positional correspondence with the through hole, and wherein after the pin layer is formed on the side of the dielectric layer away from the chip, the semiconductor packaging method further comprises:
forming a solder layer, the solder layer covering a surface of the conductive pillars raised from the dielectric layer, the solder layer filling the recess.

4. The semiconductor packaging method according to claim 3, wherein a width-to-depth ratio of the through hole is greater than or equal to 1/3.

5. The semiconductor packaging method according to claim 4, wherein a depth of the through hole ranges from 60 µm to 100 µm, and a thickness of the conductive feature at a bottom of the through hole ranges from 10 µm to 50 µm.

6. The semiconductor packaging method according to claim 1, wherein the pin layer has a thickness greater than 30 µm.

7. The semiconductor packaging method according to claim 1, further comprising: forming a heat dissipation layer on the side of the dielectric layer away from the chip; after which the semiconductor packaging method further comprises: forming a solder layer, the solder layer covering a surface of the heat dissipation layer exposed from the dielectric layer.

8. The semiconductor packaging method according to claim 1, wherein the rewiring layer comprises a plurality of rewiring structures which are spaced apart from one another and provided with hollows.

9. A semiconductor packaging structure, comprising:
an encapsulating structure, the encapsulating structure comprising an encapsulation layer and a chip, the chip provided on a front side thereof with a plurality of bonding pads, the encapsulation layer covering a backside and a side face of the chip;
a rewiring layer located on a side of the encapsulating structure close to the front side of the chip, the rewiring layer configured for external connection of the bonding pads on the chip;
a dielectric layer covering the rewiring layer, the dielectric layer provided therein with a through hole in which the rewiring layer is exposed; and
a pin layer located on a side of the dielectric layer away from the chip, the pin layer electrically connected to the rewiring layer through the through hole.

10. The semiconductor packaging structure according to claim 9, wherein the pin layer comprises a plurality of conductive pillars which are spaced apart from one another and raised from the dielectric layer, and wherein the semiconductor packaging structure further comprises a solder layer, the solder layer covering a surface of the conductive pillars raised from the dielectric layer.

11. The semiconductor packaging structure according to claim 9, wherein the pin layer comprises a plurality of conductive pillars which are spaced apart from one another and raised from the dielectric layer, and a conductive feature is provided in the through hole so that the pin layer is electrically connected to the rewiring layer by the conductive feature, wherein a recess is formed in the conductive feature in positional correspondence with the through hole, and wherein the semiconductor packaging structure further comprises a solder layer, the solder layer covering a surface of the conductive pillars raised from a surface of the dielectric layer, the solder layer filling the recess.

12. The semiconductor packaging structure according to claim 11, wherein a width-to-depth ratio of the through hole is greater than or equal to 1/3.

13. The semiconductor packaging structure according to claim 12, wherein a depth of the through hole ranges from 60 µm to 100 µm, and a thickness of the conductive feature at a bottom of the through hole ranges from 10 µm to 50 µm.

14. The semiconductor packaging structure according to claim 9, wherein the pin layer has a thickness greater than 30 µm.

15. The semiconductor packaging structure according to claim 9, wherein the rewiring layer comprises a plurality of rewiring structures which are spaced apart from one another and provided with hollows.

16. The semiconductor packaging structure according to claim 15, further comprising:
a protective layer formed on the front side of the chip, wherein the protective layer comprises openings in which the plurality of bonding pads are exposed; and
conductive structures formed in the openings in the protective layer, wherein the rewiring structures are electrically connected to the bonding pads by the conductive structures.

17. The semiconductor packaging structure according to claim 16, further comprising:
a heat dissipation layer located on the side of the dielectric layer away from the chip, wherein the pin layer comprises a plurality of conductive pillars which are spaced apart from one another and located around the heat dissipation layer.
